# EUROPEAN PATENT APPLICATION

(11) **EP 1 947 212 A1**
(43) Date of publication of application: **23.07.2008**
(21) Application number: 08100664.5
(22) Date of filing: 18.01.2008
(51) Int. Cl.: C23C 14/56, C23C 16/54

(54) **Method for making an architectural laminate**

(30) Priority: 19.01.2007 TW 96102085
(71) Applicant: Xxentria Technology Materials Co., Ltd., Tainan Hsien (TW)
(72) Inventor: Cheng, Hsien-Sung, TAINAN HSIEN (TW); Cheng, Hsien-Te, TAINAN HSIEN (TW)
(74) Representative: Collin, Jérôme

(57) **Abstract**

A method for making an architectural laminate (2) includes: (a) providing a sheet-like strip (22) wound on a supplying roller (32); (b) conveying the sheet-like strip (22) to pass through a deposition chamber (303); (c) depositing a face layer (24) on the sheet-like strip (22) through vapor deposition techniques; and (d) storing the deposited sheet-like strip (20) on a take-up roller (33).

## Description

### CROSS-REFERENCE TO RELATED APPLICATION

This application claims priority of Taiwanese application no. 096102085, filed on January 19, 2007.

This invention relates to a method for making an architectural laminate, more particularly to a method involving depositing a face layer of a metal-containing material through vapor deposition techniques.

A conventional architectural laminate usually includes a substrate made from a plastic or a metal, and a fluorocarbon-based coating formed on the substrate so as to protect a surface of the substrate. Formation of the fluorocarbon-based coating is conducted by applying a paint containing a polyvinylidene fluoride resin, a dye, and an additive dissolved in an isophorone solvent, to the substrate. However, the iosphorone solvent is harmful to the environment.

Therefore, the object of the present invention is to provide a method for making an architectural laminate that can overcome the aforesaid drawback associated with the prior art.

According to the present invention, a method for making an architectural laminate comprises: (a) providing a sheet-like strip wound on a supplying roller;(b) conveying the sheet-like strip to pass through a deposition chamber;(c) depositing a face layer on the sheet-like strip through vapor deposition techniques; and (d) storing the deposited sheet-like strip on a take-up roller.

Other features and advantages of the present invention will become apparent in the following detailed description of the preferred embodiment of this invention, with reference to the accompanying drawings, in which:
Fig. 1 is a schematic sectional view of an apparatus used in the preferred embodiment of a method for making an architectural laminate according to this invention; and
Fig. 2 is a fragmentary sectional view of the architectural laminate formed according to the preferred embodiment.

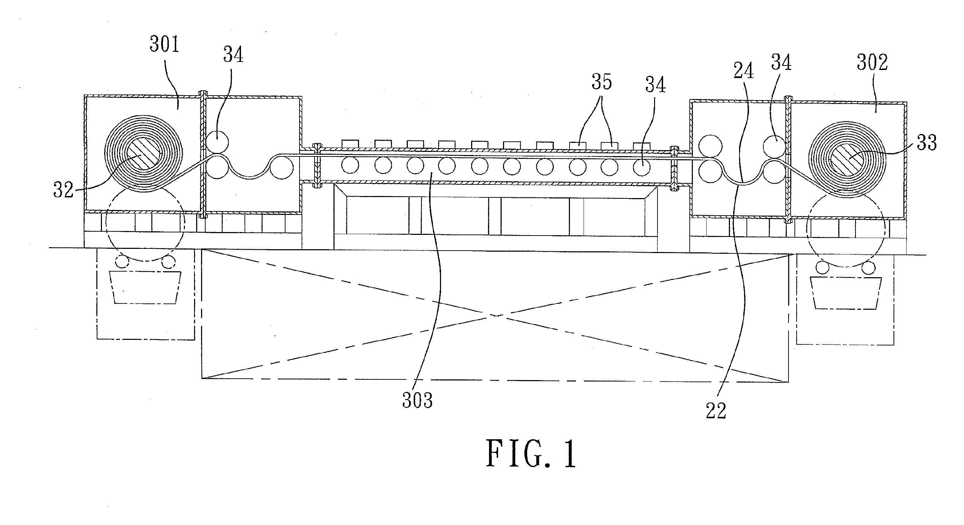

Fig. 1 illustrates an apparatus used in the preferred embodiment of a method for making an architectural laminate 2 according to this invention.

The method includes: (a) providing a sheet-like strip 22 wound on a supplying roller 32 in a supplying chamber 301; (b) conveying the sheet-like strip 22 to pass through the supplying chamber 301, a deposition chamber 303, and into a take-up chamber 302 using a plurality of rollers 34;(c) depositing a face layer 24 on an upper side 221 of the sheet-like strip 22 through vapor deposition techniques in the deposition chamber 303,thereby forming a deposited sheet-like strip 20; and (d) storing the deposited sheet-like strip 20 on a take-up roller 33 in the take-up chamber 302.

Preferably, the deposition chamber 303 is provided with a plurality of target units 35 aligned along the length of the deposition chamber 303.

Preferably, the face layer 24 is made from a metal-containing material selected from the group consisting of Ti, Cu, Cr, Zn, A1, Pt, Au, Ag, Ni, TiN, A1N, TiAlN, CrN, SiO₂, TiO₂, and combinations thereof, and has a layer thickness ranging from 0.3 µm to 10 µm so as to be able to exhibit a colored reflection.

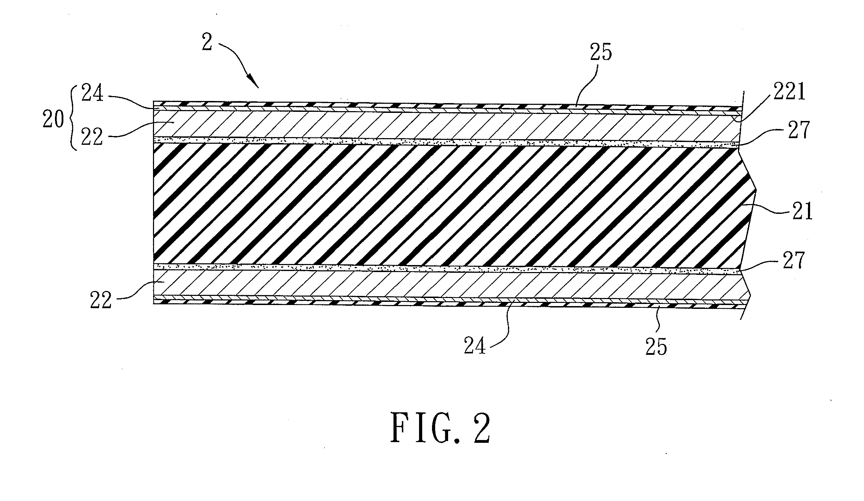

The method further includes laminating a core layer 21 (see Fig. 2) with the deposited sheet-like strip 20 such that the core layer 21 is disposed on one side of the deposited sheet-like strip 20 opposite to the face layer 24.

Preferably, the core layer 21 is a plastic made from a material selected from the group consisting of polyethylene, polypropylene, ethylene-vinyl acetate (EVA) copolymer, and a foamable material of EVA copolymer, or an inorganic material, such as Al(OH)₃, Mg(OH)₂, MgO, Al, CaSiO₃, and rock wool, or a paper sheet. In this preferred embodiment, the core layer 21 is made from ethylene-vinyl acetate copolymer.

Preferably, the sheet-like strip 22 is made from a metallic material selected from the group consisting of aluminum alloy sheet, zinc-plated steel sheet, aluminum zinc-plated steel sheet, aluminum zinc magnesium-plated steel sheet, titanium alloy sheet, copper alloy sheet, stainless steel, zinc alloy sheet, and paint coated steel sheet.

In the preferred embodiment, the method further includes forming a transparent layer 25 on the face layer 24 so as to provide a protection.

In the preferred embodiment, the method further includes applying an adhesive 27 to the core layer 21 so as to adhere the core layer 21 to the deposited sheet-like strip 20 thereon.

By using vapor deposition techniques in the method of this invention for forming the deposited sheet-like strip 20, the aforesaid drawback associated with the prior art can be eliminated.

## Claims

1. A method for making an architectural laminate (2), **characterized by**:
(a) providing a sheet-like strip (22) wound on a supplying roller (32);
(b) conveying the sheet-like strip (22) to pass through a deposition chamber (303);
(c) depositing a face layer (24) on the sheet-like strip (22) through vapor deposition techniques; and
(d) storing the deposited sheet-like strip (20) on a take-up roller (33).

2. The method of Claim 1, **characterized in that** the face layer (24) is made from a material selected from the group consisting of Ti, Cu, Cr, Zn, A1, Pt, Au, Ag, Ni, TiN, A1N, TiAlN, CrN, SiO₂, TiO₂, and combinations thereof.

3. The method of Claim 1, further **characterized by** laminating a core layer (21) with the deposited sheet-like strip (20).

4. The method of Claim 3, further **characterized by** applying an adhesive (27) to the core layer (21) so as to adhere the core layer (21) to the deposited sheet-like strip (20) thereon.

5. The method of Claim 3, **characterized in that** the core layer (21) is made from a material selected from the group consisting of polyethylene, polypropylene, ethylene-vinyl acetate copolymer, Al(OH)₃, Mg(OH)₂, MgO, Al, CaSiO₃, rock wool, and paper.

6. The method of Claim 1, further **characterized by** forming a transparent layer (25) on the face layer (24).

7. The method of Claim 1, **characterized in that** the sheet-like strip (22) is made from a metallic material.

8. The method of Claim 1, **characterized in that** the face layer (24) is made from a metal-containing material, and has a layer thickness ranging from 0.3 to 10 µm.
